# EUROPEAN PATENT SPECIFICATION

(11) **EP 2 989 659 B1**
(45) Date of publication and mention of the grant of the patent: **12.06.2019**
(21) Application number: 14788491.0
(22) Date of filing: 22.04.2014
(51) Int. Cl.: H01L 23/367, G06F 1/20, H05K 7/20, F28F 3/04, F21V 29/00, H01L 23/473, H01L 23/467

(54) **HEAT SINK HAVING A COOLING STRUCTURE WITH DECREASING STRUCTURE DENSITY**
KÜHLKÖRPER MIT KÜHLSTRUKTUR MIT ABNEHMENDER STRUKTURDICHTE
DISSIPATEUR THERMIQUE DOTÉ D'UNE STRUCTURE DE REFROIDISSEMENT AVEC UNE DENSITÉ DE STRUCTURE DÉCROISSANTE

(30) Priority: 23.04.2013 DK 201300242
(43) Date of publication of application: 02.03.2016
(73) Proprietor: Alexiou & Tryde Holding ApS, 1874 Frederiksberg C (DK)
(72) Inventor: ALEXIOU, Alexandra, DK-1874 Frederiksberg C (DK); TRYDE, Jacob, Willer, DK-1874 Frederiksberg C (DK)
(74) Representative: Nordic Patent Service A/S
(86) International application number: PCT/DK2014/050107
(87) International publication number: WO 2014/173419

(56) References cited:
- EP-A1- 0 253 126
- EP-A1- 0 623 952
- WO-A1-2004/070266
- WO-A1-2013/053174
- CA-A- 1 238 428
- CN-A- 101 436 574
- CN-Y- 201 429 055
- DE-A1- 10 055 454
- DE-A1- 10 134 187
- DE-A1- 10 244 805
- DE-A1- 19 806 978
- DE-U1- 8 509 176
- JP-A- S58 125 855
- SU-A1- 1 485 329
- US-A- 3 149 666
- US-A- 3 219 885
- US-A- 3 220 471
- US-A- 3 437 328
- US-A- 4 734 139
- US-A- 5 158 136
- US-A- 6 085 830
- US-A1- 2002 018 338
- US-A1- 2002 144 809
- US-A1- 2002 148 595
- US-A1- 2002 182 397
- US-A1- 2002 195 229
- US-A1- 2003 131 973
- US-A1- 2004 035 554
- US-A1- 2004 190 257
- US-A1- 2004 244 948
- US-A1- 2005 247 432
- US-A1- 2006 137 856
- US-A1- 2006 250 776
- US-A1- 2007 284 092
- US-A1- 2008 105 413
- US-A1- 2008 149 304
- US-A1- 2010 091 463
- US-A1- 2011 086 196
- US-A1- 2011 108 237
- US-A1- 2011 297 361
- US-A1- 2012 006 514
- US-B1- 6 295 202
- US-B1- 6 390 181
- US-B1- 6 623 687
- US-B1- 6 789 610
- US-B1- 6 807 059
- US-B2- 7 353 860
- WONG, M. ET AL.: 'Convective heat transfer and pressure losses across novel beat sinks fabricated by Selective Laser Melting' INTERNATIONAL JOURNAL OF HEAT AND MASS TRANSFER vol. 52, no. 1-2, January 2009, pages 281 - 288, XP025713930
- TSOPANOS, S. ET AL.: 'The manufacture of micro cross-flow heat exchangers by selective laser melting;' PROCEEDINGS OF THE FIFTH INTERNATIONAL CONFERENCE ON ENHANCED, COMPACT AND ULTRA-COMPACT HEAT EXCHANGERS: SCIENCE ENGINEERING AND TECHNOLOGY September 2005, XP055086490 Retrieved from the Internet: <URL:http://dc.engconfintl.org/heatexchange rfall2005/45>

## Description

### FIELD OF THE INVENTION

The present invention relates generally to heat sinks, and more particularly to heat sinks comprising a cooling structure with an outwards decreasing material density. The heat sinks of the present invention may for example be used for dissipating heat generated by electrical or electronic components and assemblies.

### BACKGROUND OF THE INVENTION

With the rapid rise in power dissipated by integrated circuits, improved heat sink designs are needed to decrease the thermal resistance between them and forced air streams. Manufacturing methods such as extrusion, machining and die-casting have been used to fabricate conventional longitudinal fin designs. Although these technologies add relatively little cost, they preclude the fabrication of more complex heatsink designs. But more complex structures may be needed to improve the performance of heat sinks.

Heat sinks of a more complex structure are described by Hernon et al. in US Patent App. No 2009/0321045 A1. Hernon et al. introduces the concept of using 3-D printing of a sacrificial pattern and subsequent investment casting to form complex structured heat sinks. A typical 3-D printer uses a laser and a liquid photopolymer to produce a 3-D form by a succession of solid layers, with an example being a stereolithography rapid prototyping system.

One 3-D printing process or additive manufacturing process being well suited for manufacturing complex structured heat sinks is the selective laser melting (SLM) process. The process called selective laser melting started at the Fraunhofer Institute ILT in Aachen, Germany, in 1995.

Selective laser melting (SLM) is an additive manufacturing process that uses 3D CAD data as a digital information source and energy in the form of a high powered laser beam (usually an ytterbium fiber laser) to create three-dimensional metal parts by fusing fine metallic powders together. The industry's standard term is laser sintering, although this is acknowledged as a misnomer because the process fully melts the metal into a solid homogeneous mass. The process starts by slicing the 3D CAD file data into layers, usually from 20 to 100 micrometres thick, creating a 2D image of each layer; this file format is the industry standard .stl file used on most layer-based 3D printing or stereolithography technologies. This file is then loaded into a file preparation software package that assigns parameters, values and physical supports that allow the file to be interpreted and built by different types of additive manufacturing machines.

With SLM thin layers of atomized fine metal powder are evenly distributed using a coating mechanism onto a substrate plate, usually metal, that is fastened to an indexing table that moves in the vertical (Z) axis. This takes place inside a chamber containing a tightly controlled atmosphere of inert gas, either argon or nitrogen at oxygen levels below 500 parts per million. Once each layer has been distributed each 2D slice of the part geometry is fused by selectively applying the laser energy to the powder surface, by directing the focused laser beam using two high frequency scanning mirrors in the X and Y axes. The laser energy is intense enough to permit full melting (welding) of the particles to form solid metal. The process is repeated layer after layer until the part is complete.

The types of applications most suited to the SLM process are complex geometries and structures with thin walls and hidden voids or channels. Advantage can be gained when producing hybrid forms where solid and partially formed or lattice type geometries can be produced together to create a single object.

The heat sinks described by Hernon et al. have a base part and a heat exchange part being monolithically connected together. Thus, the base part and the heat exchange part are a single, continuous entity produced as a single, cast unit. The heat exchange part of the heat sinks described by Hernon et al. have complex three dimensional structures, but none of the structures suggested by Hernon et al. have a decreasing material thickness.

US Patent App. No 2008/0149304 discloses several three-dimensional heat sinks made up of different oriented interconnected lattice elements. The heat sinks are produced by an additive process, such as an additive deposition process or a metallic additive process. The additive deposition process is a shape metal deposition process that may use an electron beam gun or a laser and a powdered metal, metal alloy or composite material.

The heat sinks are plate heat sinks composed of multiple, thin, slightly-separated plates that have large surface areas and fluid flow passages for heat transfer.

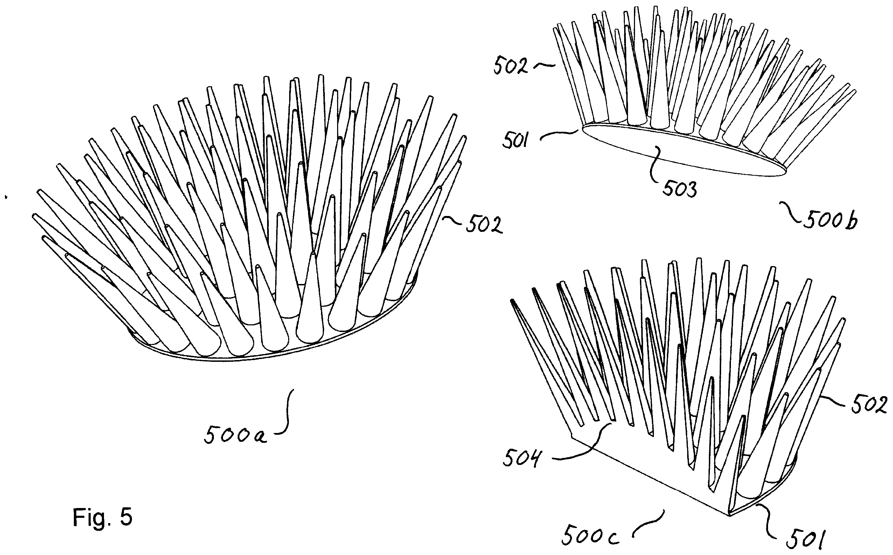

WO 2013/053174 also discloses a three-dimensional heat sink made up of different oriented interconnected lattice elements. The heat sink comprises a plate-shaped heat conductive part connected to a heat source and a heat dissipation part connected to the heat conductive part, wherein the heat dissipation part holds heat conductive strips forming a lattice, see Fig. 5, which lattice is connected to the heat conductive part.

Heat sinks having a three-dimensional structure are also disclosed in US Patent App. No 2002/0144809. The method for producing the disclosed heat sink devices includes specifying a three-dimensional structure as a plurality of laminae, producing the laminae from sheets of working material, stacking the laminae according to a predetermined sequence with a guiding structure, and connecting the laminae.

The heat exchange part of the heat sinks described in US Patent App. No 2008/0149304, WO 2013/053174, and US Patent App. No 2002/014480 have complex three dimensional structures, but none of the disclosed structures have a material thickness, which decreases with the distance to the body part for connecting to a heat generating device and which also decreases with the distance to an axis perpendicular to the body part.

However, it has been found by the present inventor that very efficient heat sinks can be obtained by using a cooling or heat exchange structure, in which the material density decreases with the distance from the heat generating device, which is to be cooled, and also decreases with the distance to an axis perpendicular to the body part, which is to be connected to the heat generating device.

### SUMMARY OF THE INVENTION

According to the present invention there is provided a heat sink for cooling a heat generating device, said heat sink comprising:
a body part with a first surface for contacting the heat generating device; and
a cooling part connected to a second surface of the body part and holding a cooling structure;
wherein the material density of the cooling structure decreases with increasing distance to the second and/or first surface of the body part;
wherein when defining a center line or axis being perpendicular to the first surface of the body part and going through the center of the body part, the material density of the cooling structure decreases with increasing distance in all directions to said center axis; and
wherein the material thickness of the cooling structure decreases with increasing distance to the second surface of the body part; or
wherein at least part of the second surface forms an upwards curved or dome or cone or pyramid shaped upper surface to which the cooling structure is connected.

The decrease in the material density of the cooling structure with increasing distance to the second surface and/or the first surface of the body part, may be observed or measured when taken along a direction being substantially perpendicular to the first surface of the body part.

According to an embodiment of the invention, the first surface is a first outer surface of the body part and the second surface is a second outer surface of the body part. It is also within one or more embodiments of the invention that the second surface is opposing the first surface.

It is within one or more embodiments of the invention that the cooling part holds a mesh or grid or lattice like cooling structure, which may be a three dimensional mesh or grid or lattice like cooling structure.

The cooling structure may be made of a material structure defining air and/or liquid flow passages, and the total space taken up by the air and/or liquid flow passages within the cooling structure may increase with increasing distance to the second and/or first surface of the body part. The cooling structure may define a number of air and/or liquid flow passages of different directions, whereby a number of air and/or liquid flow passages intersect or cross each other.

For embodiments of the invention having a lattice like cooling structure, then at least part of the lattice like cooling structure may be formed by different oriented lattice elements being connected to each other at connecting points, and the material density may decrease with increasing distance to the second and/or first surface of the body part for several different oriented lattice elements being connected to each other at connecting points.

For embodiments having a mesh or grid or lattice like cooling structure, then the mesh or grid like cooling structure may be made of a material structure defining air and/or liquid flow passages, and the total space taken up by the air and/or liquid flow passages within the cooling structure may be larger than the total space taken up by the material parts of the cooling structure.

The present invention also covers embodiments having a mesh or grid or lattice like cooling structure, wherein the three dimensional grid or lattice like cooling structure is a space grid structure. Here, the space grid structure may be a substantially modular space grid structure.

For embodiments having a mesh or grid or lattice like cooling structure, the mesh or grid or lattice like cooling structure may be made of a solid material structure defining air and/or liquid flow passages. However, the invention also covers embodiments, wherein the mesh or grid or lattice like cooling structure is made of a material structure defining air and/or liquid flow passages, and wherein at least part of the material structure is hollow.

For embodiments having a mesh or grid or lattice like cooling structure, the mesh or grid or lattice like cooling structure may be made of a material structure defining air and/or liquid flow passages having a diameter increasing from below 5 mm to above 5 mm from the inner part of the cooling structure connected to the second surface and to the outer bond of the cooling structure.

It is within one or more embodiments of the invention that the thickness of the body part increases inwards from the outer edge or edges of the body part to the centre of the body part. The thickness of the body part may increase inwards in all directions from the outer edge or edges of the body part to the centre of the body part. The thickness of the body part when measured along any edge part may be smaller than the thickness measured at the centre of the body part.

The present invention covers one or more embodiments, wherein the first surface of the body part covers at least a centre part of an outer surface of the body part.

The present invention also covers one or more embodiments wherein the body part has a lower outer surface holding the first surface, and wherein at least part of the second surface forms a substantially upwards extending upper surface to which the cooling structure is connected

For the heat sinks of the present invention, it is preferred that the body part and the cooling part with the cooling structure is monolithically connected to each other.

Different materials may be used when manufacturing the heat sinks of the invention. Thus, the body part, the cooling part and/or the cooling structure may be made of a metal such as Aluminum or Copper, or made of a technical ceramics such as Aluminium Nitride (AIN) or Silicon Carbide, or made of a composite containing graphite and/or carbon such as graphene or carbon nanotubes.

In order to obtain a larger surface of the heat sinks cooling structure, the present invention also covers embodiments, wherein at least part of the cooling structure has a micro-structured surface. The present invention also covers embodiments, wherein at least part of the cooling structure has a nano-structured surface.

According to the present invention, there is also provided a method for producing a heat sink according to one or more of the above mentioned embodiments, wherein the method comprises an additive manufacturing process. Here, the additive manufacturing process may include a selective laser melting (SLM) process. The SLM process may uses a metal for forming the three dimensional mesh or grid like cooling structure, wherein the metal may be Aluminum or Copper.

Various embodiments are understood from the following detailed description, when read with the accompanying figures.

### BRIEF DESCRIPTION OF THE DRAWINGS

Fig. 1 illustrates prior art heat sinks;
Fig. 2 illustrates a first embodiment of a heat sink with a mesh, grid or lattice like cooling structure according to the invention;
Fig. 3 illustrates the heat distribution in the heat sink of Fig. 2;
Fig. 4 illustrates the airflow through the heat sink of Fig. 2;
Fig. 5 illustrates a heat sink with pin like fins;
Fig. 6 illustrates a heat sink with plate like fins; Fig. 7 illustrates a double heat sink with plate like fins;
Fig. 8 illustrates a laptop computer with an integrated heat sink;
Fig. 9 illustrates a tablet computer with an integrated heat sink;
Fig. 10 illustrates a cylindrical shaped heat sink designed for water cooling;
Fig. 11 illustrates an embodiment of a heat sink with a mesh, grid or lattice like cooling structure according to the invention;
Fig. 12 illustrates an embodiment of a heat sink with a mesh, grid or lattice like cooling structure;
Fig. 13 illustrates a fourth embodiment of a heat sink with a mesh, grid or lattice like cooling structure according to the invention;
Fig. 14 illustrates an embodiment of a heat sink with a mesh, grid or lattice like cooling structure;
Fig. 15 illustrates anembodiment of a heat sink with a mesh, grid or lattice like cooling structure;
Fig. 16 illustrates a LED spot lamp having a chassis integrated with a heat sink with a mesh, grid or lattice like cooling structure;
Fig. 17 illustrates a cabinet integrated with a heat sink with a mesh, grid or lattice like cooling structure;
Fig. 18 illustrates another embodiment of a cabinet integrated with a heat sink with a mesh, grid or lattice like cooling structure;
Fig. 19 illustrates a LED light engine having a back surface for connecting to a heat sink;
Fig. 20 illustrates a computer processor unit, CPU, having a surface for connecting to a heat sink;
Fig. 21 illustrates an embodiment of a heat sink with a mesh, grid or lattice like cooling structure according to the invention;
Fig. 22 illustrates an embodiment of a heat sink with a mesh, grid or lattice like cooling structure;
Fig. 23 illustrates an embodiment of a heat sink with a mesh, grid or lattice like cooling structure; and
Fig. 24 illustrates a computer case with an integrated heat sink.

### DETAILED DEDCRIPTION OF THE INVENTION

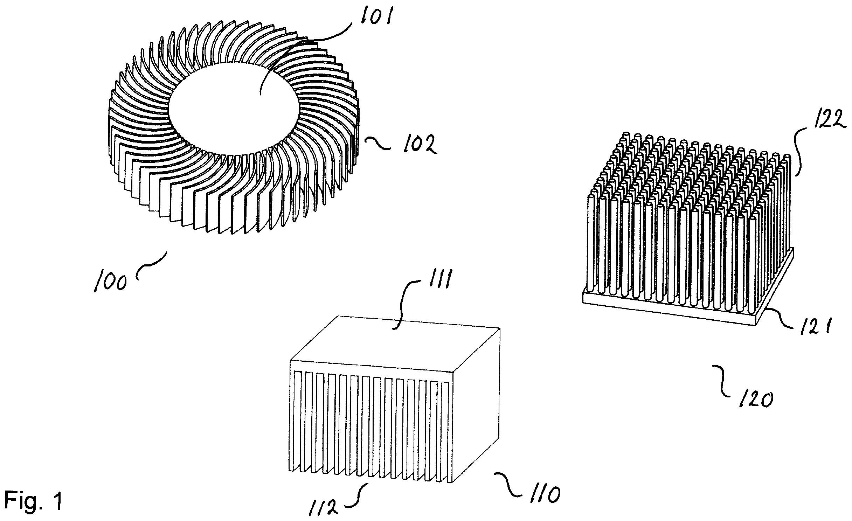

Fig. 1 illustrates three prior art heat sinks 100, 110, and 120. The first heat sink 100 has a base or core 101 and curved cooling fins 102 connected to the core 101. The fins 102 all have the same curve, and the material thickness of the fins 102 is equal all the way. The heat sink 110 also has a base or core 111 and straight formed fins 112 connected to the core 111, with the material thickness of the fins 112 being equal all the way along the fins 112. The heat sink 120 also has a base or core 121 and pin formed fins 122 connected to the core 121, with the material thickness of the fins 122 being equal all the way along the fins 122. The heat sinks 100, 110, and 120 are representative of the class of heat sinks formed by conventional methods including extrusion, machining and die-casting.

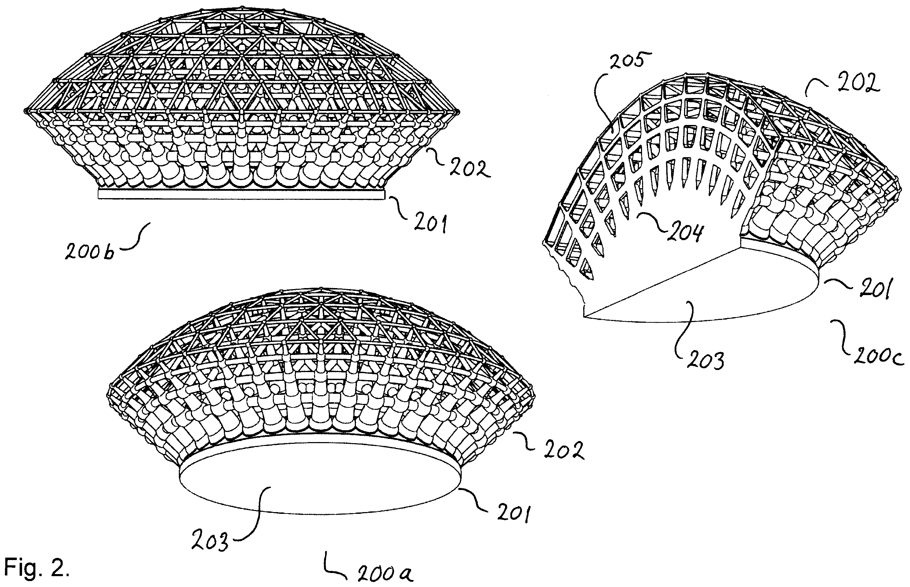

Fig. 2 illustrates a first embodiment of a heat sink 200 according to the present invention, which heat sink 200 may be formed using a 3-D printing and casting process, such as the selective laser melting (SLM) process. The heat sink 200 has a body part 201 holding a cooling part 202 with a mesh, grid or lattice like cooling structure. The heat sink 200 is shown at different angles as 200a and 200b and as a cut through versions as 200c and 200d. The body part 201 has a first surface 203 for contacting a heat generating device, and a second surface 204 holding or connected to the cooling part 202, which again comprises or is formed by the grid like cooling structure. The body part 201 and the cooling part 202 with the cooling structure are monolithically connected to each other. As used herein, monolithic is defined to mean that the body part 201 and the cooling part 202 of the heat sink are a single, continuous entity.

For the heat sink 200 of Fig. 2, the body part 201 has a plane, lower surface 203 for contacting the heat generating device, while the body part 201 has a substantially upwards extending or upwards curved upper surface for connecting to the cooling part 202 with the cooling structure. The upwards curved body part 201 may be considered as being substantially dome shaped, and the thickness of the body part 201 increases inwards from the outer edge to the centre. It is seen that the thickness of the body part 201 increases inwards in all directions from the outer edge or edges of the body part 201 to the centre of the body part. It is also seen that the thickness of the body part 201 when measured along any edge part is smaller than the thickness measured at the centre of the body part 201.

The cooling part 202 holds a three dimensional mesh, grid or lattice like cooling structure, and the material thickness and thereby the material density of the cooling structure decreases with increasing distance to the second and first surfaces 204, 203 of the body part 201. The mesh, grid or lattice like cooling structure defines air or liquid flow passages 205, and the mesh, grid or lattice is formed so that the total space taken up by the air or liquid flow passages within the cooling structure increases with increasing distance to the second surface 204 of the body part 201. The total space taken up by the flow passages within the cooling structure may be larger than the total space taken up by the material parts of the cooling structure. For the heat sink 200, the cooling structure is formed so that it defines flow passages of different directions, whereby a number of flow passages intersect or cross each other. The cooling structure of the heat sink 200 may be considered as a lattice like structure, which is formed by different oriented lattice elements being connected to each other at connecting points. The material density of these different oriented lattice elements decreases with increasing distance to the second surface 204 of the body part 201.

The cooling structure of the cooling part 202 may be considered as a space grid structure. The space grid may be formed in a regular or repeating way, while still having the material thickness decreasing with the distance to the surface 204. For the heat sink 200 of Fig. 2, the cooling structure is made of a solid material structure defining the flow passages. However, the present invention also covers embodiments, wherein the material structure defining the mesh, grid or lattice like cooling structure is hollow.

It is preferred that the diameter of the flow passages 205 increases from below 5 mm to above 5 mm from the inner part of the cooling structure connected to the second surface 204 and to the outer bond of the cooling structure.

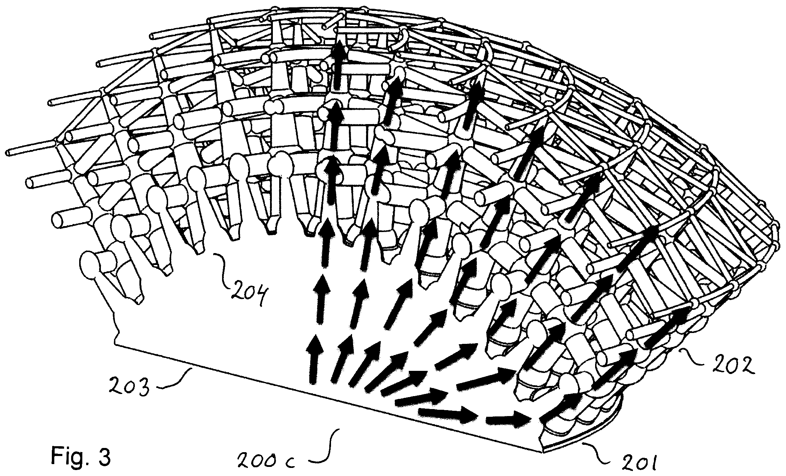

Fig. 3 illustrates the heat distribution in the heat sink 200 of Fig. 2, when a heat generating device is located at the centre of the first surface 203 of the body part 201. Fig. 3 shows the cut through heat sink 200d, and due to the upwards curved body part 201, the thermal distances from the centre part of the first surface 203 to the different parts of the second surface 204 are almost equal, whereby the heat will be distributed equally at the second surface 204 and the start of the cooling structure.

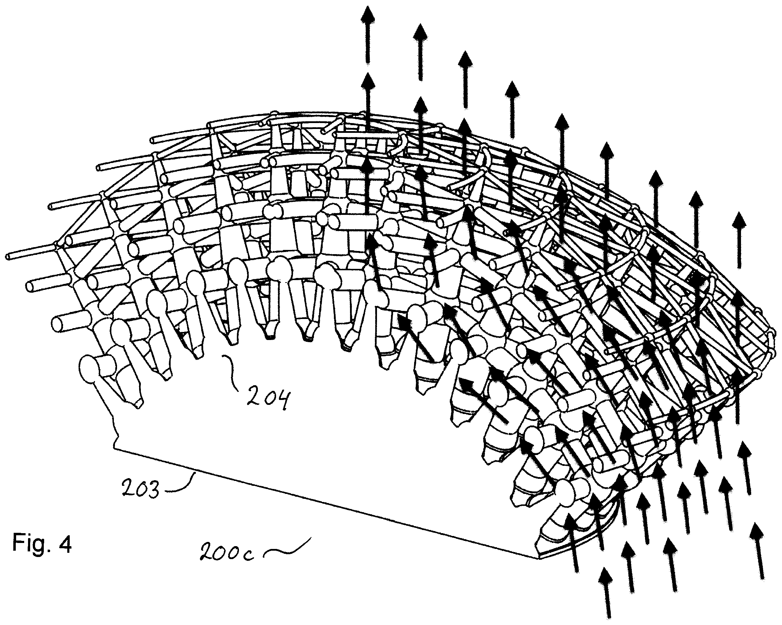

Fig. 4 illustrates the airflow through the heat sink 200 of Fig. 2, for the situation when a heat generating device is located at the first surface 203 of the body part 201. Fig. 4 shows the cut through heat sink 200d. The cooling structure heats the air, thereby creating a flow of air from the outskirt of the cooling structure to centre and further to the upper boundary of the cooling structure.

Fig. 5 illustrates a heat 500 sink with pin like fins 502. The heat sink 500 may also be formed using a 3-D printing and casting process, such as the selective laser melting (SLM) process. The heat sink 500 has a body part 501 holding a cooling part with a cooling structure being a number of pin like fins 502. The heat sink 500 is show at different angles as 500a and 500b and as a cut through versions as 500c. The body part 501 has a first surface 503 for contacting a heat generating device, and a second surface 504 holding or connected to the cooling part with the cooling fins 502. The body part 501 and the cooling fins 502 are monolithically connected to each other.

For the heat sink 500 of Fig. 5, the body part 501 has a plane, lower surface 503 for contacting the heat generating device, while the body part 501 has a substantially upwards extending or upwards curved or domed shaped upper surface for connecting to the cooling fins 502. The thickness or diameter and thereby the material density of the cooling fins 502 decreases with increasing distance to the second surface 504 of the body part 501. The total space taken up by air within the cooling structure or cooling fins 502 may be larger than the total space taken up by the cooling fins 502. For the heat sink 500 of Fig. 5, the body part 501 and the cooling structure or fins 502 are made of a solid material structure.

The body part 501 of the heat sink 500 in Fig. 5 is domed shaped. The thickness of the body part 501 increases inwards in all directions from the outer edge or edges of the body part 501 to the centre of the body part, and the thickness of the body part 501 when measured along any edge part is smaller than the thickness measured at the centre of the body part 501.

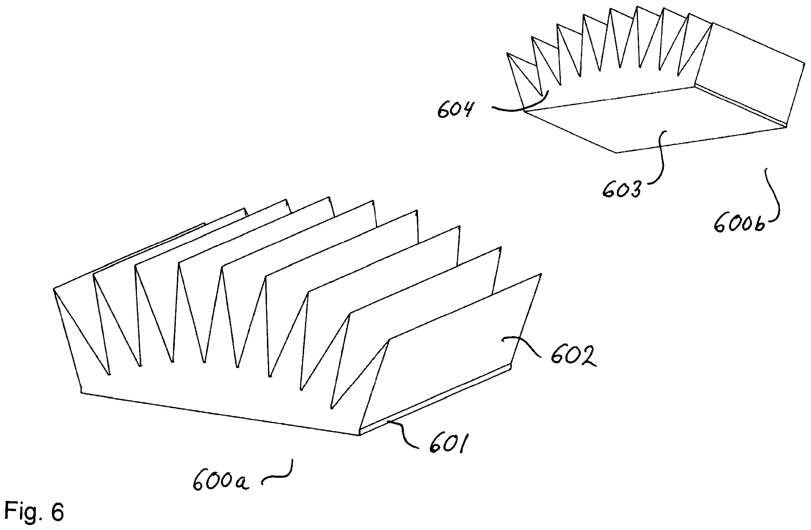

Fig. 6 illustrates a heat sink 600 with plate like fins 602. The heat sink 600 may also be formed using a 3-D printing and casting process, such as the selective laser melting (SLM) process. The heat sink 600 has a body part 601 holding a cooling part with a cooling structure being a number of plate like fins 602. The heat sink 600 is show at different angles as 600a and 600b. The body part 601 has a first plane surface 603 for contacting a heat generating device, and a second upwards curved surface 604 holding or connected to the cooling part with the cooling fins 602. The body part 601 and the cooling fins 602 are monolithically connected to each other. The thickness or width and thereby the material density of the plate like cooling fins 602 decreases with increasing distance to the second surface 604 of the body part 601. Also here, the body part 601 and the cooling structure or fins 602 are made of a solid material structure.

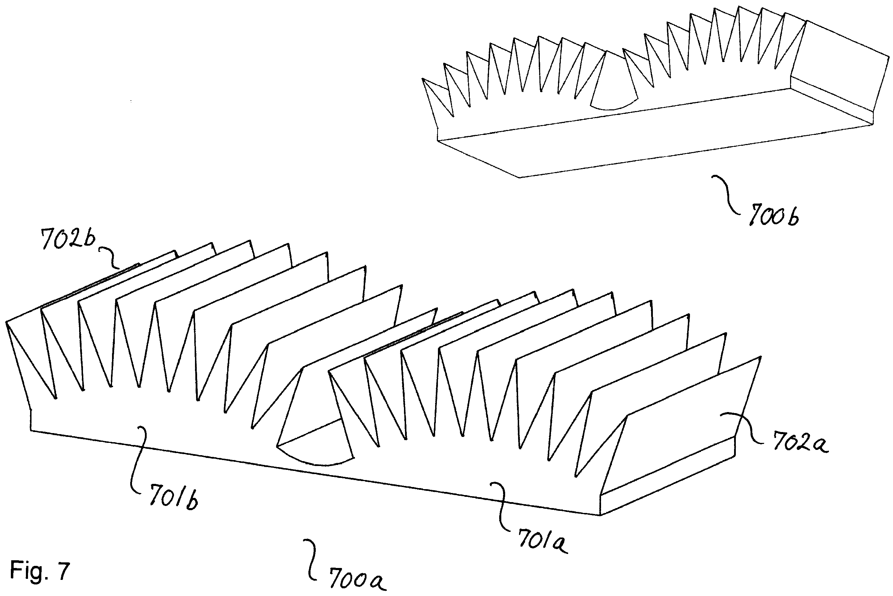

Fig. 7 illustrates a double heat sink 700 with plate like fins 702a, 702b. The heat sink 700 is made of two heat sinks being equal to the heat sink 600 of fig. 6. Thus, the heat sink 700 has two body parts 701a, 701b each holding a cooling part with a cooling structure being a number of plate like fins 702a, 702b. The heat sink 700 is show at different angles as 700a and 700b. The thickness or width and thereby the material density of the plate like cooling fins 702a, 702b decreases with increasing distance to the body part 701a, 701b.

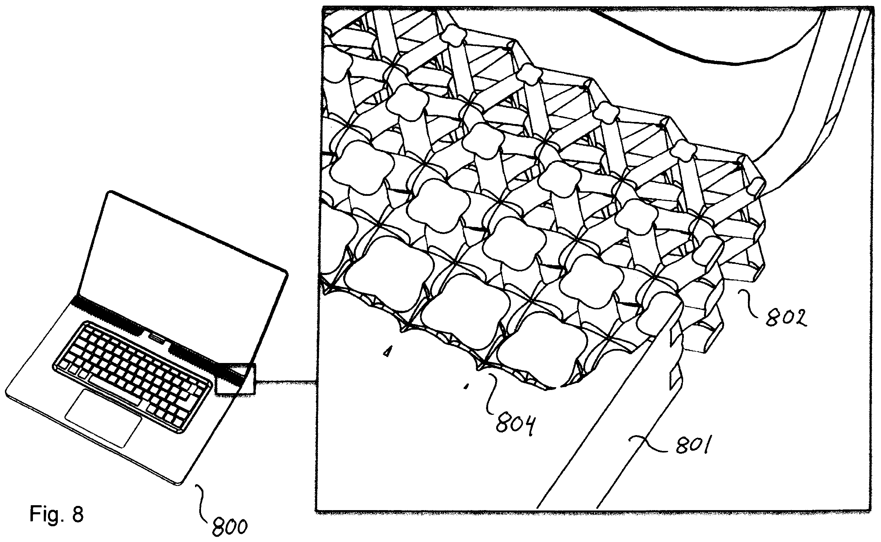

Fig. 8 illustrates a laptop computer 800 with an integrated heat sink. The heat sink has a body part 801, which may be an integral part of the laptop cover or chassis, where the heat generating devices such as integrated circuits, may be secured or contacting an inner surface of the cover or chassis, which may then be considered as a first surface of the body part 801. The heat sink further holds a cooling part with a cooling structure 802, which is connected to a second surface 804 of the body part 801.The cooling structure 802 shown in Fig. 8 is a three dimensional mesh, grid or lattice like cooling structure 802, and the material thickness and thereby the material density of the cooling structure 802 decreases with increasing distance to the second surface 804 of the body part 801. The cooling structure 802 may be considered as a lattice like structure, which is formed by different oriented lattice elements being connected to each other at connecting points. The material density of these different oriented lattice elements decreases with increasing distance to the second surface 804 of the body part 801. The cooling structure of the laptop computer 800 may also have other forms, such as the plate like fins 602 of Fig. 6.

Also here, the body part 801 and the cooling structure 802 are monolithically connected to each other, and the cooling structure 802 is made of a solid material structure.

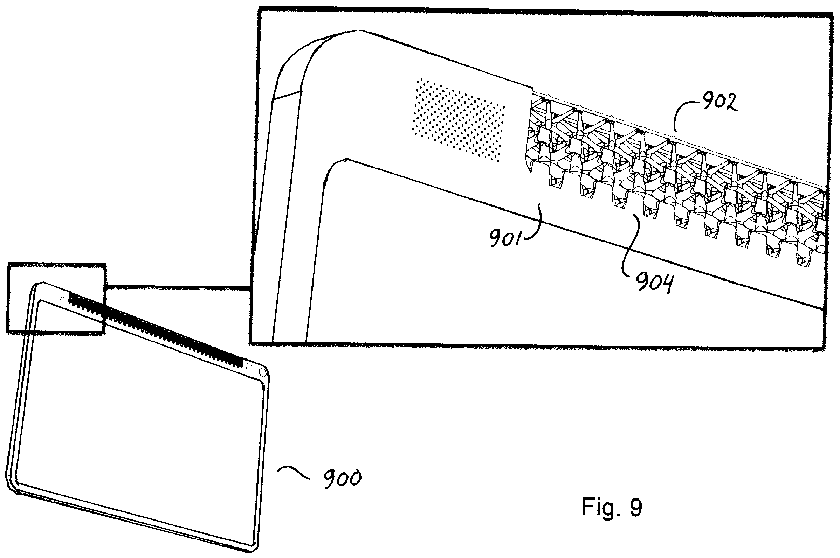

Fig. 9 illustrates a tablet computer 900 with an integrated heat sink. The principle is the same as for the heat sink of Fig. 8. The heat sink has a body part 901, which may be an integral part of the tablet cover or chassis, where the inner surface of the cover or chassis may be considered as a first surface of the body part 901. The heat sink further holds a cooling part with a cooling structure 902, which is connected to a second surface 904 of the body part 901. Also here the shown cooling structure 902 is a three dimensional mesh, grid or lattice like cooling structure 902, and the material thickness and thereby the material density of the cooling structure 902 decreases with increasing distance to the second surface 904 of the body part 901. The cooling structure 902 may also here be considered as a lattice like structure, which is formed by different oriented lattice elements being connected to each other at connecting points, where the material density of these different oriented lattice elements decreases with increasing distance to the second surface 904 of the body part 901.

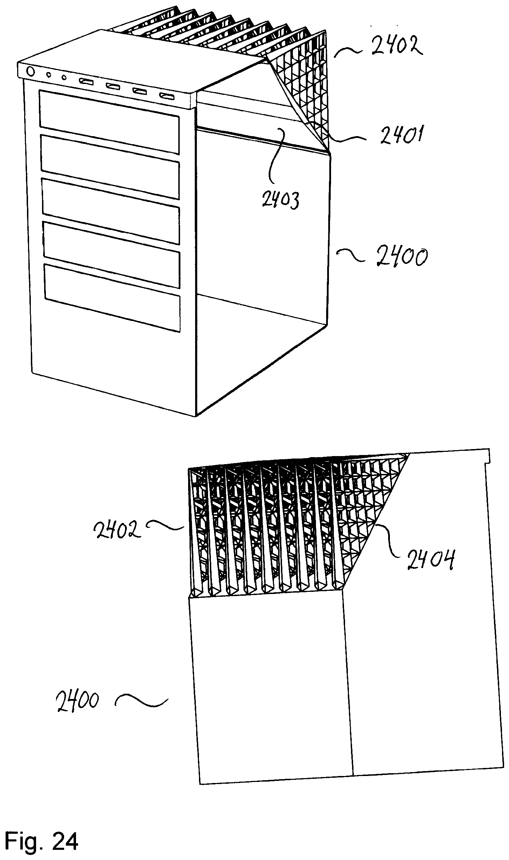

Fig. 24 illustrates a computer case 2400 with an integrated heat sink. The principle is the same as for the heat sinks of Figs. 8 and 9. The heat sink has a body part 2401, which may be an integral part of the case or chassis 2400, where an inner surface of the case or chassis may be considered as a first surface 2403 of the body part 2401. The heat sink further holds a cooling part with a cooling structure 2402, which is connected to a second surface 2404 of the body part 2401. Also here the shown cooling structure 2402 is a three dimensional mesh, grid or lattice like cooling structure 2402, and the material thickness and thereby the material density of the cooling structure 2402 decreases with increasing distance to the second surface 2404 and the first surface 2403 of the body part 2401. The cooling structure 2402 may also here be considered as a lattice like structure, which is formed by different oriented lattice elements being connected to each other at connecting points, where the material density of these different oriented lattice elements decreases with increasing distance to the second surface 2404 of the body part 2401.

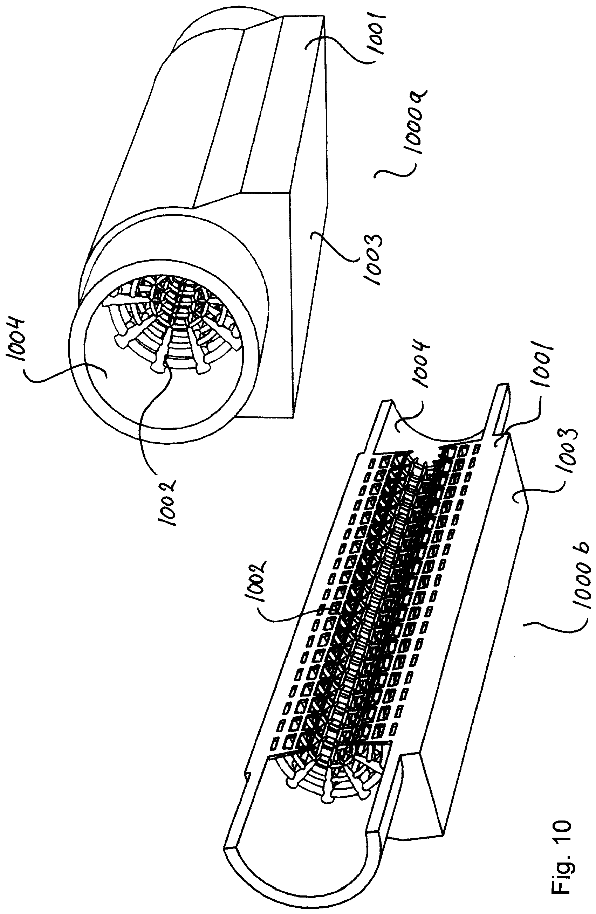

Fig. 10 illustrates a cylindrical shaped heat sink 1000 designed for water cooling. The heat sink 1000 is show in whole as 1000a and as a cut through versions as 1000b. The heat sink 1000 has a body part 1001 holding a cooling part with a cooling structure 1002. The body part 1001 has a first, outer surface 1003 for contacting a heat generating device, and a second, inner surface 1004 holding or connected to the cooling part with the cooling structure 1002 being inwards directed. Also here the shown cooling structure 1002 is a three dimensional mesh, grid or lattice like cooling structure 1002, and the material thickness and thereby the material density of the cooling structure 1002 has an internal graduating structure and decreases with increasing distance to the second, inner surface 1004 of the body part 1001. Also here, the cooling structure 1002 may be considered as a lattice like structure, which is formed by different oriented lattice elements being connected to each other at connecting points, where the material density of these different oriented lattice elements decreases with increasing distance to the second surface 1004 of the body part 1001.The heat sink 1000 has a tubular shaped body part 1001, whereby a fluid, such as water, may pass through the interior of the heat sink, thereby cooling the cooling structure 1002.

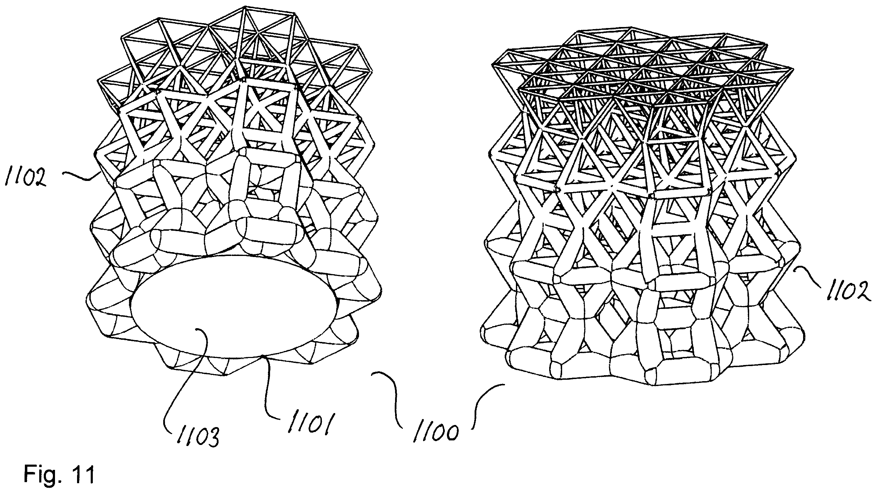

Figs. 11-15 and 21-23 illustrate several embodiments of a heat sink with a mesh, grid or lattice like cooling structure. The heat sink 1100 of Fig. 11 has a cooling part with a cooling structure 1102 having a diameter larger than the body part 1101. The body part 1101 has a plane, first surface 1003 and may have a substantially upwards extending or upwards curved upper surface for connecting to the cooling part with the cooling structure 1102. The material thickness and thereby the material density of the cooling structure 1102 decreases with increasing distance to the second surface (not shown) and to the first surface 1103 of the body part 1101 when taken along a direction being substantially perpendicular to the first, lower surface 1103 of the body part 1101. The cooling structure 1102 may be considered as a lattice like structure, which is formed by different oriented lattice elements being connected to each other at connecting points, where the material density of these different oriented lattice elements decreases with increasing distance to the second surface and the first surface 1103 of the body part 1101, when taken along a direction being substantially perpendicular to the first, lower surface 1103 of the body part 1101.

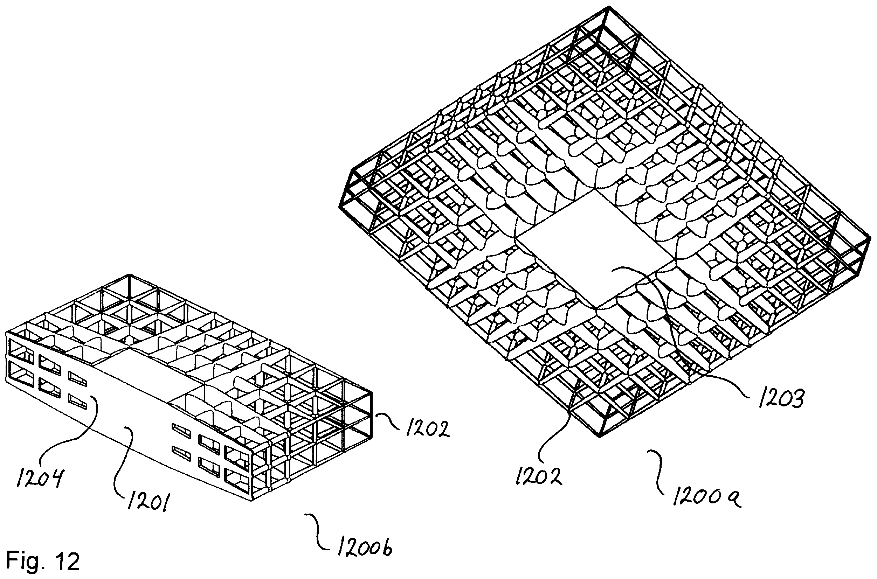

The heat sink 1200 of Fig. 12 is shown in whole as 1200a and as a cut through versions as 1200b. The body part 1201 has a plane first surface 1203 for connecting to a heat generating device, with the four side walls of the body part defining the second surface 1204 and the cooling part with the cooling structure 1202 being connected to all four side walls 1204 of body part 1201. The material thickness and thereby the material density of the cooling structure 1202 decreases with increasing distance to the second surface 1204. The cooling structure 1202 may be considered as a lattice like structure, which is formed by different oriented lattice elements being connected to each other at connecting points, where the material density of these different oriented lattice elements decreases with increasing distance to the second surface 1204 of the body part 1201.

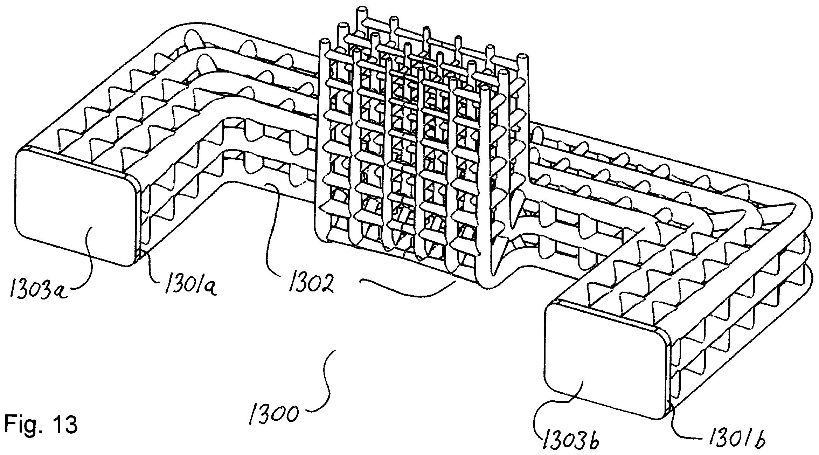

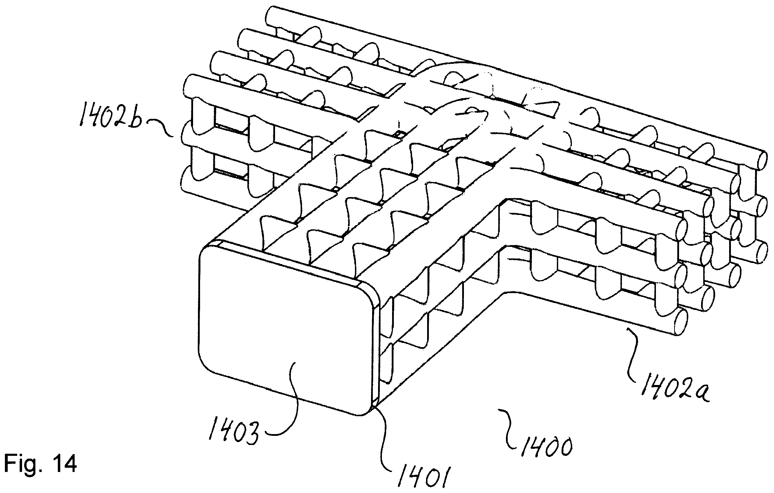

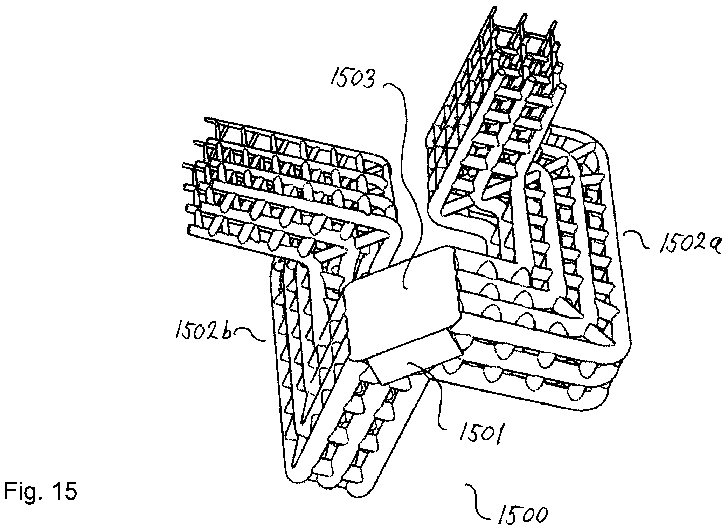

The heat sink 1300 of Fig. 13 has a special design with two body parts 1301a, 1301b being connected together by the cooling part with the cooling structure 1302. Each body part 1301a, 1301b has a corresponding first surface 1303a, 1303b for connecting to a heat generating device. The heat sink 1400 of Fig. 14 has a single body part 1401 with a first surface 1403 for connecting to a heat generating device, while the cooling structure of the cooling part divides into two cooling structures 1402a, 1402b, where the material thickness and thereby the material density of the cooling structures 1402a, 1402b decreases with increasing distance to the second surface (not shown) of the body part 1401. The heat sink 1500 of Fig. 15 is a variation of the heat sink 1400 of Fig. 14, and thus also has a single body part 1501 with a first surface 1503 for connecting to a heat generating device, while the cooling structure of the cooling part is divided in two cooling structures 1502a, 1502b, where the material thickness and thereby the material density of the cooling structures 1502a, 1502b decreases with increasing distance to the second surface (not shown) of the body part 1501.

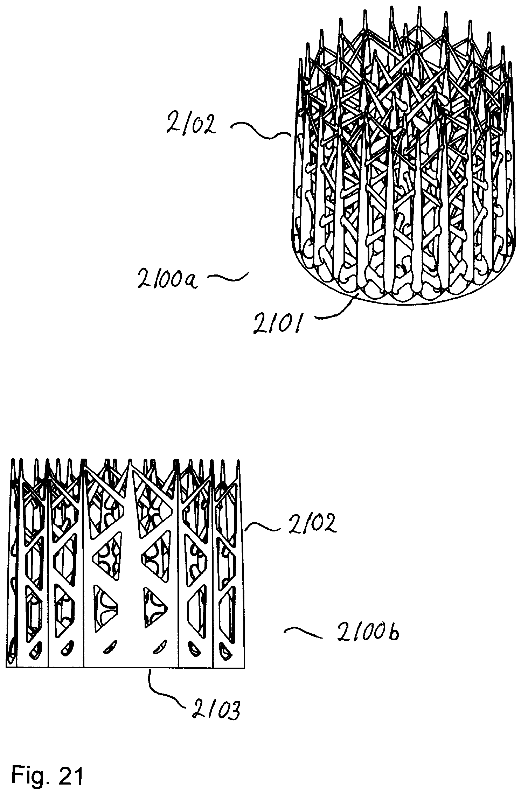

The heat sink 2100 of Fig. 21 is shown in whole as 2100a and as a cut through versions as 2100b. The heat sink 2100 has a cooling part with a cooling structure 2102, which has a diameter equal to the body part 2101. The body part 2101 has a plane, first surface 2103 for connecting to a heat generating device. The upper part of the body part 2101, to which the cooling structure is connected, is defining the second surface of the body part 2101. The material thickness and thereby the material density of the cooling structure 2102 decreases with increasing distance to both the second surface and the first surface 2103 of the body part 2101 when taken along a direction being substantially perpendicular to the first, lower surface 2103 of the body part 2101. It is also seen that when defining a center line or axis being substantially perpendicular to the first surface 2103 of the body part 2101 and going through the center of the body part 2101, the material density of the cooling structure 2102 or at least part of the cooling structure decreases with increasing distance to this center axis. Also here, the cooling structure 2102 may be considered as a lattice like structure, which is formed by different oriented lattice elements being connected to each other at connecting points, where the material density of these different oriented lattice elements decreases with increasing distance to the second surface and the first surface 2103 of the body part 2101.

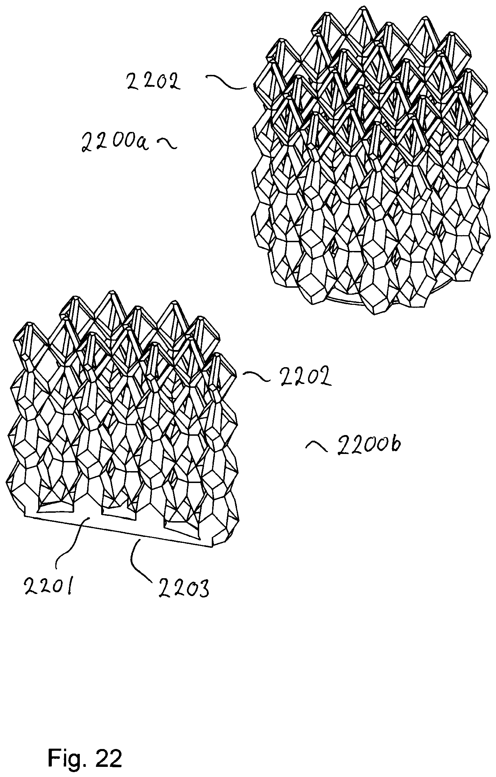

The heat sink 2200 of Fig. 22 is shown in whole as 2200a and as a cut through versions as 2200b. The heat sink 2200 has a cooling part with a cooling structure 2202, which has a diameter equal to the body part 2201. The body part 2201 has a plane, first surface 2103 for connecting to a heat generating device. The upper part of the body part 2201, to which the cooling structure is connected, is defining the second surface of the body part 2201. The material thickness and thereby the material density of the cooling structure 2202 decreases with increasing distance to both the second surface and the first surface 2203 of the body part 2201 when taken along a direction being substantially perpendicular to the first, lower surface 2203 of the body part 2201. The cooling structure 2202 may be considered as a lattice like structure, which is formed by different oriented lattice elements being connected to each other at connecting points, where the material density of these different oriented lattice elements decreases with increasing distance to the second surface and the first surface 2203 of the body part 2201.

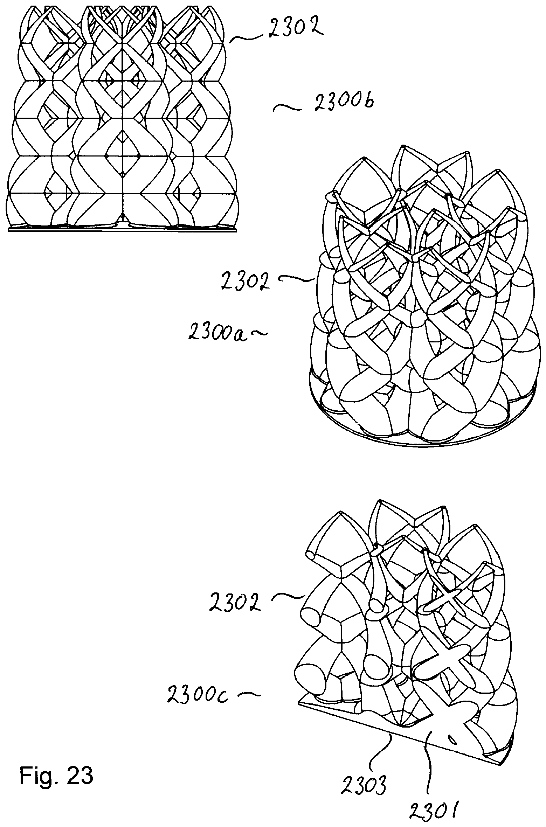

The heat sink 2300 of Fig. 23 is shown in whole as 2300a and 2300b, where 2300b is a side view, and as a cut through versions as 2300c. The heat sink 2300 has a cooling part with a cooling structure 2302, which has a diameter equal to the body part 2301. The body part 2301 has a plane, first surface 2303 for connecting to a heat generating device. The upper part of the body part 2301, to which the cooling structure is connected, is defining the second surface of the body part 2301. The material thickness and thereby the material density of the cooling structure 2302 decreases with increasing distance to both the second surface and the first surface 2303 of the body part 2301 when taken along a direction being substantially perpendicular to the first, lower surface 2303 of the body part 2301. Also here, the cooling structure 2302 may be considered as a lattice like structure, which is formed by different oriented lattice elements being connected to each other at connecting points, where the material density of these different oriented lattice elements decreases with increasing distance to the second surface and the first surface 2303 of the body part 2301, when taken along a direction being substantially perpendicular to the first, lower surface 2303 of the body part 2301.

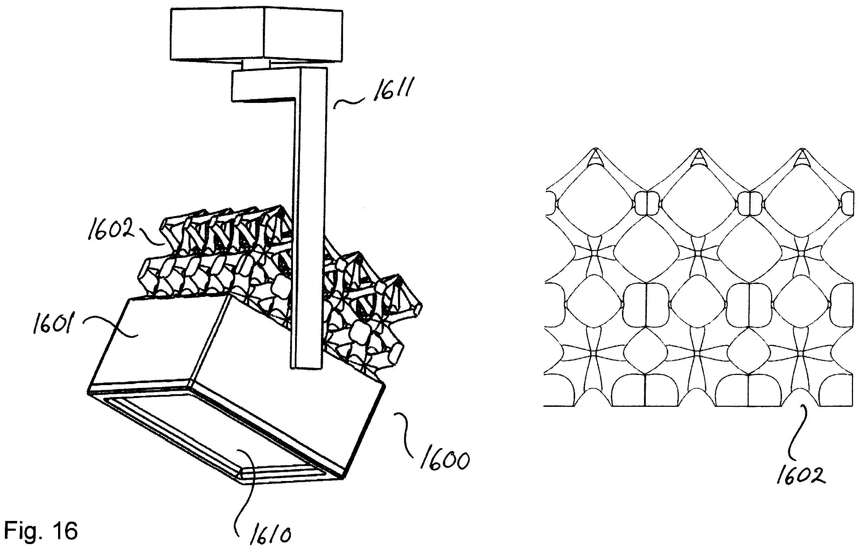

Fig. 16 illustrates a LED spot lamp 1610 having a chassis 1601 integrated with a heat sink 1600 with a mesh, grid or lattice like cooling structure 1602. The lamp 1610 is mounted on a stand 1611. The body part 1601 of the heat sink 1600 makes up the chassis, and the first surface of the body part 1601 is a first, inner surface being part of the chassis. The cooling part with the cooling structure 1602 is connected on top of the chassis 1601, whereby the top of the chassis holds the second surface connected to the cooling structure 1602. The cooling structure 1602 may be considered as a lattice like structure, which is formed by different oriented lattice elements being connected to each other at connecting points, where the material density of these different oriented lattice elements decreases with increasing distance to the second surface of the chassis or body part 1601.

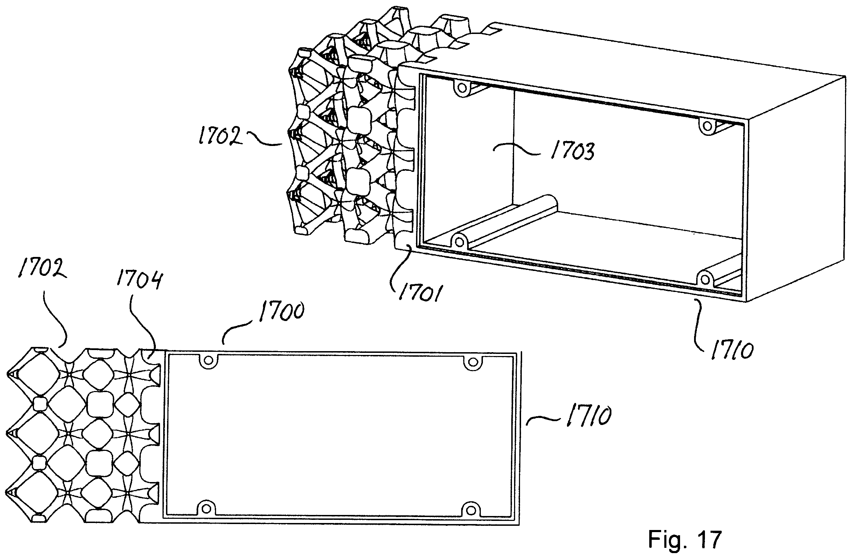

Fig. 17 illustrates a cabinet 1710 integrated with a heat sink 1700 with a mesh, grid or lattice like cooling structure 1702. The body part 1701 of the heat sink 1700 makes up the top part of the cabinet 1710, and the first surface of the body part 1701 is a first, inner surface 1703 to which a heat generating device may be connected. The upper part of the body part 1701 holds the second, outer surface 1704, to which the cooling part with the cooling structure 1702 is connected. The cooling structure 1702 may be considered as a lattice like structure, which is formed by different oriented lattice elements being connected to each other at connecting points, where the material density of these different oriented lattice elements decreases with increasing distance to the second surface 1704 of the body part 1701.

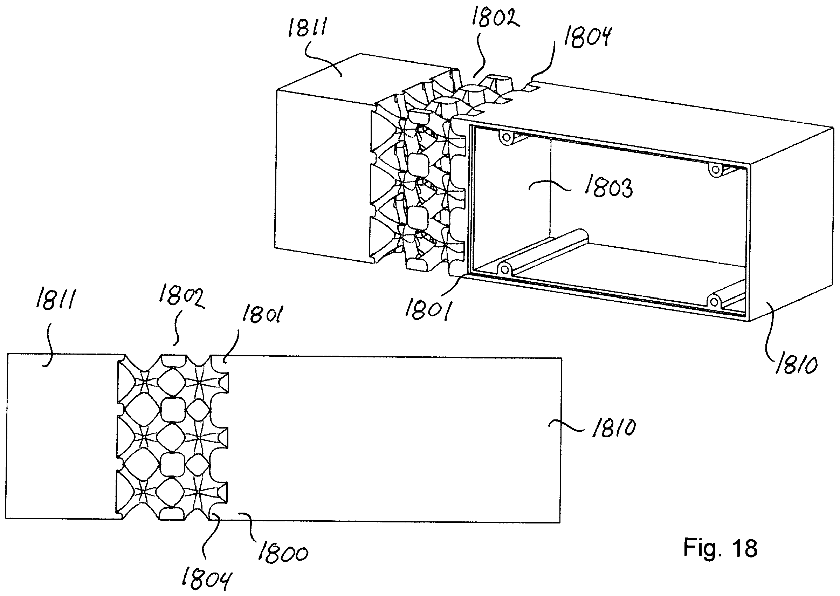

Fig. 18 illustrates another embodiment of a cabinet 1810 integrated with a heat sink 1800 with a mesh, grid or lattice like cooling structure 1802. Also here, the body part 1801 of the heat sink 1800 makes up the top part of the cabinet 1810, and the first surface of the body part 1801 is a first, inner surface 1803 to which a heat generating device may be connected. The upper part of the body part 1801 holds the second, outer surface 1804, to which the cooling part with the cooling structure 1802 is connected. For this embodiment of a heat sink 1800, the top end of the cooling structure 1802 is connected to a solid cooling body 1811. Thus, the material thickness or density of the cooling structure 1802 decreases with the distance to the second surface 1804 or to the body part 1801 as long as the cooling structure is made up of the grid or lattice like structure 1802, while the density of the cooling structure increases or stops decreasing when the cooling structure becomes the cooling body 1811.

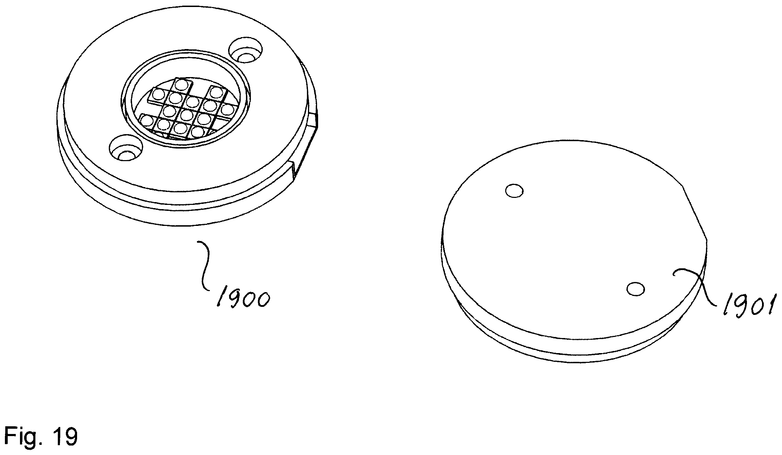

Fig. 19 illustrates a LED light engine 1900 having a back surface 1901 for connecting to a heat sink. The light engine 1900 may be an Osram PrevaLED® type LED light engine.

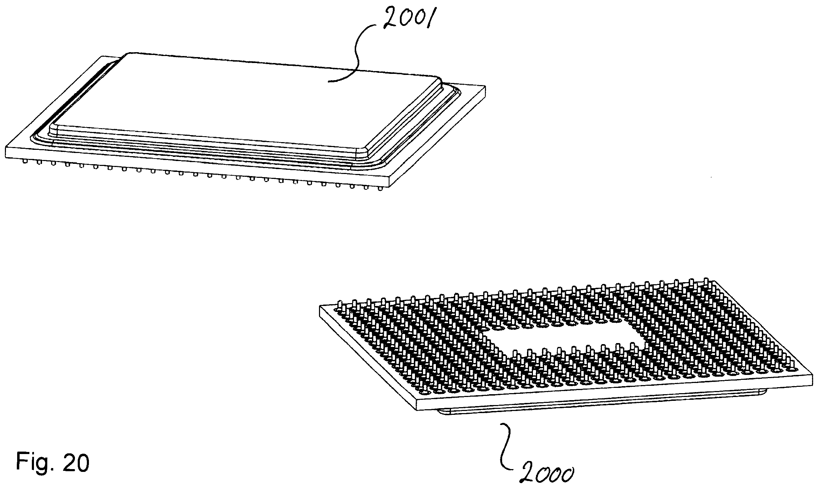

Fig. 20 illustrates a computer processor unit, CPU, 2000 having a surface 2001 for connecting to a heat.
The heat sink structures discussed above and illustrated in Figs. 2-18 and 21-24, can be made or formed using a 3-D printing and casting process, which may be an additive manufacturing process, such as the selective laser melting (SLM) process. The SLM process may use a metal for forming the heat sink with the cooling structure. Here, the metal may be Aluminum or Copper. However, other materials may also be used to form the heat sinks by a SLM process. Thus, the heat sink and cooling structure may be made of a technical ceramics such as Aluminium Nitride (AlN) or Silicon Carbide, or may be made of a composite containing graphite and/or carbon such as graphene or carbon nanotubes.

It is also within embodiments of the present invention, that at least part of the cooling structure has a micro-structured surface or a nano-structured surface.

## Claims

1. A heat sink (200, 1100, 2100) for cooling a heat generating device, said heat sink comprising:
a body part (201, 1101, 2101) with a first surface (203, 1103, 2103) for contacting the heat generating device; and
a cooling part connected to a second surface (204) of the body part and including a cooling structure (202, 1102, 2102);
wherein the material density of the cooling structure (202, 1102, 2102) decreases with increasing distance to the second and/or first surface of the body part;
wherein the cooling part holds a three dimensional grid or lattice like cooling structure (202, 1102, 2102); and
wherein when defining a center line or axis being perpendicular to the first surface (201, 1101, 2101) of the body part and going through the center of the body part, the material density of the cooling structure decreases with increasing distance in all directions to said center axis; **characterized in that**
the material thickness of the cooling structure (202, 1102, 2102) decreases with increasing distance to the second surface of the body part; or **characterized in that**
at least part of the second surface (204) forms an upwards curved or dome or cone or pyramid shaped upper surface to which the cooling structure (202, 1102) is connected.

2. A heat sink (200, 1100, 2100) according to claim 1, wherein the cooling structure (202, 1102, 2102) defines a number of air and/or liquid flow passages of different directions, whereby a number of air and/or liquid flow passages intersect or cross each other;

3. A heat sink (200, 1100) according to claim 1 or 2, wherein the thickness of the body part (201, 1101) when measured along any edge part is smaller than the thickness measured at the centre of the body part.

4. A heat sink (200, 1100, 2100) according to any one of the claims 1 to 3, wherein the first surface (203, 1103, 2103) is a first outer surface of the body part (201, 1101, 2101) and the second surface (204) is a second outer surface of the body part.

5. A heat sink (200, 1100) according to any one of the claims 1 to 4, wherein the body part (201, 1101) has a lower outer surface holding the first surface (203, 1103), and wherein at least part of the second surface (204) forms an upwards extending upper surface to which the cooling structure (202, 1102) is connected.

6. A heat sink (200, 1100, 2100) according to any one of the claims 1 to 5, wherein at least part of the lattice like cooling structure (202, 1102, 2102) is formed by different oriented lattice elements being connected to each other at connecting points, and wherein the material density decreases with increasing distance to the second and/or first surface of the body part (201, 1101, 2101) for several different oriented lattice elements being connected to each other at connecting points; and/or
wherein the grid or lattice like cooling structure (200, 1100, 2100) is made of a material structure defining air and/or liquid flow passages, and wherein the total space taken up by the air and/or liquid flow passages within the cooling structure is larger than the total space taken up by the material parts of the cooling structure.

7. A heat sink (200, 1100, 2100) according to any one of the claims 1 to 6, wherein the three dimensional grid or lattice like cooling structure (202, 1102, 2102) is a space grid structure.

8. A heat sink (200, 1100, 2100) according to any one of the claims 1 to 7, wherein the grid or lattice like cooling structure (202, 1102, 2102) is made of a solid material structure defining air and/or liquid flow passages; or
wherein the grid or lattice like cooling structure is made of a material structure defining air and/or liquid flow passages, and wherein at least part of the material structure is hollow.

9. A heat sink (200, 1100, 2100) according to any one of the claims 1 to 8, wherein the body part and the cooling part with the cooling structure (202, 1102, 2102) is monolithically connected to each other.

10. A heat sink (200, 1100, 2100) according to any one of the claims 1 to 9, wherein the cooling structure (202, 1102, 2102) is made of a metal such as Aluminum or Copper; or
wherein the cooling structure (202, 1102, 2102) is made of a technical ceramics such as Aluminium Nitride (AlN) or Silicon Carbide; or
wherein the cooling structure (202, 1102, 2102) is made of a composite containing graphite and/or carbon such as graphene or carbon nanotubes.

11. A heat sink (200, 1100, 2100) according to any one of the claims 1 to 10, wherein at least part of the cooling structure has a micro-structured surface; and/or wherein at least part of the cooling structure has a nano-structured surface.

12. A method for producing a heat sink (200, 1100, 2100) comprising a cooling structure 202, 1102, 2102) according to any one of the claims 1 to 11, said method comprising an additive manufacturing process.

13. A method according to claim 12, wherein the additive manufacturing process includes a selective laser melting (SLM) process.

## Patentansprüche

1. Kühlkörper (200, 1100, 2100) zum Kühlen eines Wärme erzeugenden Bausteins, wobei der Kühlkörper Folgendes umfasst:
einen Körperteil (201, 1101, 2101) mit einer ersten Oberfläche (203, 1103, 2103) zum Berühren des Wärme erzeugenden Bausteins und
einen Kühlteil, der mit einer zweiten Oberfläche (204) des Körperteils verbunden ist und eine Kühlstruktur (202, 1102, 2102) einschließt,
wobei die Materialdichte der Kühlstruktur (202, 1102, 2102) mit zunehmender Entfernung von der zweiten und/oder der ersten Oberfläche des Körperteils abnimmt, wobei der Kühlteil eine dreidimensionale gitter- oder netzartige Kühlstruktur (202, 1102, 2102) hält und wobei, wenn eine Mittellinie oder -achse so definiert wird, dass sie senkrecht zu der ersten Oberfläche (201, 1101, 2101) des Körperteils ist und durch die Mitte des Körperteils geht, die Materialdichte der Kühlstruktur mit zunehmender Entfernung in allen Richtungen zu der Mittelachse abnimmt, **dadurch gekennzeichnet, dass** die Materialdicke der Kühlstruktur (202, 1102, 2102) mit zunehmender Entfernung zu der zweiten Oberfläche des Körperteils abnimmt, oder **dadurch gekennzeichnet, dass**
wenigstens ein Teil der zweiten Oberfläche (204) eine nach oben gekrümmte oder kuppel- oder kegel- oder pyramidenförmige obere Fläche bildet, mit der die Kühlstruktur (202, 1102) verbunden ist.

2. Kühlkörper (200, 1100, 2100) nach Anspruch 1, wobei die Kühlstruktur (202, 1102, 2102) eine Anzahl von Luft- und/oder Flüssigkeitsströmungsdurchgängen unterschiedlicher Richtungen definiert, wodurch eine Anzahl von Luft- und/oder Flüssigkeitsströmungsdurchgängen einander schneiden oder kreuzen.

3. Kühlkörper (200, 1100) nach Anspruch 1 oder 2, wobei die Dicke des Körperteils (201, 1101), wenn entlang eines beliebigen Kantenteils gemessen, kleiner ist als die Dicke, gemessen an der Mitte des Körperteils.

4. Kühlkörper (200, 1100, 2100) nach einem der Ansprüche 1 bis 3, wobei die erste Fläche (203, 1103, 2103) eine erste Außenfläche des Körperteils (201, 1101, 2101) ist und die zweite Fläche (204) eine zweite Außenfläche des Körperteils ist.

5. Kühlkörper (200, 1100) nach einem der Ansprüche 1 bis 4, wobei der Körperteil (201, 1101) eine untere Außenfläche aufweist, welche die erste Fläche (203, 1103) hält, und wobei wenigstens ein Teil der zweiten Oberfläche (204) eine sich nach oben erstreckende obere Fläche bildet, mit der die Kühlstruktur (202, 1102) verbunden ist.

6. Kühlkörper (200, 1100, 2100) nach einem der Ansprüche 1 bis 5, wobei wenigstens ein Teil der netzartigen Kühlstruktur (202, 1102, 2102) durch unterschiedlich ausgerichtete Netzelemente, die an Verbindungspunkten miteinander verbunden sind, gebildet wird und wobei die Materialdichte mit zunehmender Entfernung zu der zweiten und/oder der ersten Oberfläche des Körperteils (201, 1101, 2101) für verschiedene unterschiedlich ausgerichtete Netzelemente, die an Verbindungspunkten miteinander verbunden sind, abnimmt und/oder wobei die gitter- oder netzartige Kühlstruktur (202, 1102, 2102) aus einer Materialstruktur hergestellt ist, die Luft- und/oder Flüssigkeitsströmungsdurchgänge definiert, und wobei der gesamte Raum, der durch die Luft- und/oder Flüssigkeitsströmungsdurchgänge innerhalb der Kühlstruktur eingenommen wird, größer ist als der gesamte Raum, der durch die Materialteile der Kühlstruktur eingenommen wird.

7. Kühlkörper (200, 1100, 2100) nach einem der Ansprüche 1 bis 6, wobei die dreidimensionale gitter- oder netzartige Kühlstruktur (202, 1102, 2102) eine Raumgitterstruktur ist.

8. Kühlkörper (200, 1100, 2100) nach einem der Ansprüche 1 bis 7, wobei die gitter- oder netzartige Kühlstruktur (202, 1102, 2102) aus einer massiven Materialstruktur hergestellt ist, die Luft- und/oder Flüssigkeitsströmungsdurchgänge definiert, oder
wobei die gitter- oder netzartige Kühlstruktur aus einer Materialstruktur hergestellt ist, die Luft- und/oder Flüssigkeitsströmungsdurchgänge definiert, und wobei wenigstens ein Teil der Materialstruktur hohl ist.

9. Kühlkörper (200, 1100, 2100) nach einem der Ansprüche 1 bis 8, wobei der Körperteil und der Kühlteil mit der Kühlstruktur (202, 1102, 2102) monolithisch miteinander verbunden sind.

10. Kühlkörper (200, 1100, 2100) nach einem der Ansprüche 1 bis 9, wobei die Kühlstruktur (202, 1102, 2102) aus einem Metall, wie beispielsweise Aluminium oder Kupfer, hergestellt ist, oder
wobei die Kühlstruktur (202, 1102, 2102) aus technischer Keramik, wie beispielsweise Aluminiumnitrid (AlN) oder Siliziumcarbid, hergestellt ist oder
wobei die Kühlstruktur (202, 1102, 2102) aus einem Verbundwerkstoff, der Graphit und/oder Kohlenstoff enthält, wie beispielsweise Graphen- oder Kohlenstoff-Nanoröhren, hergestellt ist.

11. Kühlkörper (200, 1100, 2100) nach einem der Ansprüche 1 bis 10, wobei wenigstens ein Teil der Kühlstruktur eine mikrostrukturierte Oberfläche aufweist und/oder wobei wenigstens ein Teil der Kühlstruktur eine nanostrukturierte Oberfläche aufweist.

12. Verfahren zum Herstellen eines Kühlkörpers (200, 1100, 2100), der eine Kühlstruktur (202, 1102, 2102) umfasst, nach einem der Ansprüche 1 bis 11, wobei das Verfahren einen additiven Fertigungsprozess umfasst.

13. Verfahren nach Anspruch 12, wobei der additive Fertigungsprozess einen Prozess des selektiven Laserschmelzens (selective laser melting - SLM) einschließt.

## Revendications

1. Dissipateur thermique (200, 1100, 2100) destiné à refroidir un dispositif générateur de chaleur, ledit dissipateur thermique comprenant :
une partie de corps (201, 1101, 2101) avec une première surface (203, 1103, 2103) destinée à toucher le dispositif générateur de chaleur ; et
une partie de refroidissement reliée à une deuxième surface (204) de la partie de corps et comprenant une structure de refroidissement (202, 1102, 2102) ;
dans lequel la densité de matériau de la structure de refroidissement (202, 1102, 2102) diminue avec une distance croissante par rapport à la deuxième et/ou première surface de la partie de corps ;
dans lequel la partie de refroidissement comporte une grille tridimensionnelle ou un treillis tridimensionnel en tant que structure de refroidissement (202, 1102, 2102) ; et
dans lequel, lors de la définition d'une ligne médiane ou d'un axe médian perpendiculaire à la première surface (201, 1101, 2101) de la partie de corps et traversant le centre de la partie de corps, la densité de matériau de la structure de refroidissement diminue avec une distance croissante dans toutes les directions dudit axe médian ; **caractérisé en ce que**
l'épaisseur de matériau de la structure de refroidissement (202, 1102, 2102) diminue avec une distance croissante par rapport à la deuxième surface de la partie de corps ; ou **caractérisé en ce que**
au moins une partie de la deuxième surface (204) forme une surface supérieure courbée vers le haut ou en forme de dôme ou de cône ou de pyramide, à laquelle la structure de refroidissement (202, 1102) est reliée.

2. Dissipateur thermique (200, 1100, 2100) selon la revendication 1, dans lequel la structure de refroidissement (202, 1102, 2102) définit un nombre de passages d'écoulement d'air et/ou de liquide dans différentes directions, de sorte qu'un nombre de passages d'écoulement d'air et/ou de liquide se croisent ou se coupent entre eux.

3. Dissipateur thermique (200, 1100) selon la revendication 1 ou 2, dans lequel l'épaisseur de la partie de corps (201, 1101), mesurée le long de n'importe quelle partie de bord, est inférieure à l'épaisseur mesurée au centre de la partie de corps.

4. Dissipateur thermique (200, 1100, 2100) selon l'une quelconque des revendications 1 à 3, dans lequel la première surface (203, 1103, 2103) est une première surface extérieure de la partie de corps (201, 1101, 2101) et la deuxième surface (204) est une deuxième surface extérieure de la partie de corps.

5. Dissipateur thermique (200, 1100) selon l'une quelconque des revendications 1 à 4, dans lequel la partie de corps (201, 1101) présente une surface extérieure inférieure comportant la première surface (203, 1103), et dans lequel au moins une partie de la deuxième surface (204) forme une surface supérieure s'étendant vers le haut, à laquelle est reliée la structure de refroidissement (202, 1102).

6. Dissipateur thermique (200, 1100, 2100) selon l'une quelconque des revendications 1 à 5, dans lequel au moins une partie de la structure de refroidissement (202, 1102, 2102) du genre treillis est constituée d'éléments de treillis orientés différemment, lesquels sont reliés les uns aux autres à des points de jonction, et dans lequel la densité de matériau diminue avec une distance croissante par rapport à la deuxième et/ou à la première surface de la partie de corps (201, 1101, 2101) pour plusieurs éléments de treillis orientés différemment reliés les uns aux autres à des points de jonction ; et/ou
dans lequel la structure de refroidissement (202, 1102, 2102) du genre grille ou treillis est constituée d'une structure de matériau définissant des passages d'écoulement d'air et/ou de liquide, et dans lequel l'espace total occupé par les passages d'écoulement d'air et/ou de liquide à l'intérieur de la structure de refroidissement est plus grand que l'espace total occupé par les parties de matériau de la structure de refroidissement.

7. Dissipateur thermique (200, 1100, 2100) selon l'une quelconque des revendications 1 à 6, dans lequel la structure de refroidissement (202, 1102, 2102) du genre grille tridimensionnelle ou treillis tridimensionnel est une structure de grille spatiale.

8. Dissipateur thermique (200, 1100, 2100) selon l'une quelconque des revendications 1 à 6, dans lequel la structure de refroidissement (202, 1102, 2102) du genre grille tridimensionnelle ou treillis tridimensionnel est constituée d'une structure de matériau solide définissant des passages d'écoulement d'air et/ou de liquide ; ou
dans lequel la structure de refroidissement du genre grille ou treillis est constituée d'une structure de matériau définissant des passages d'écoulement d'air et/ou de liquide, et dans lequel au moins une partie de la structure de matériau est creuse.

9. Dissipateur thermique (200, 1100, 2100) selon l'une quelconque des revendications 1 à 8, dans lequel la partie de corps et la partie de refroidissement avec la structure de refroidissement (202, 1102, 2102) sont reliées entre elles de façon monolithique.

10. Dissipateur thermique (200, 1100, 2100) selon l'une quelconque des revendications 1 à 9, dans lequel la structure de refroidissement (202, 1102, 2102) est constituée d'un métal tel que l'aluminium ou le cuivre ; ou
dans lequel la structure de refroidissement (202, 1102, 2102) est constituée de céramiques techniques telles que le nitrure d'aluminium (AIN) ou le carbure de silicone ; ou
dans lequel la structure de refroidissement (202, 1102, 2102) est constituée d'un composite contenant un graphite et/ou un carbone, tel que le graphène ou des nanotubes de carbone.

11. Dissipateur thermique (200, 1100, 2100) selon l'une quelconque des revendications 1 à 10, dans lequel au moins une partie de la structure de refroidissement présente une surface micro-structurée ; et/ou dans lequel au moins une partie de la structure de refroidissement présente une surface nano-structurée.

12. Procédé pour la production d'un dissipateur thermique (200, 1100, 2100) comprenant une structure de refroidissement (202, 1102, 2102) selon l'une quelconque des revendications 1 à 11, ledit procédé comprenant un processus de fabrication additive.

13. Procédé selon la revendication 12, dans lequel le processus de fabrication additive comprend un processus de fusion sélective par laser (SLM).
